## Europäisches Patentamt
## European Patent Office
## Office européen des brevets

(19)

(11) Numéro de publication: **0 191 682**
**B1**

(12)

# FASCICULE DE BREVET EUROPEEN

(45) Date de publication du fascicule du brevet:
**11.10.89**

(51) Int. Cl.⁴: **H01L 31/02, H01L 27/14**

(21) Numéro de dépôt: **86400178.9**

(22) Date de dépôt: **29.01.86**

(54) **Dispositif matriciel de détection d'un rayonnement lumineux à écrans froids individuels intégrés dans un substrat et son procédé de fabrication.**

(30) Priorité: **06.02.85 FR 8501649**

(43) Date de publication de la demande:
**20.08.86 Bulletin 86/34**

(45) Mention de la délivrance du brevet:
**11.10.89 Bulletin 89/41**

(84) Etats contractants désignés:
**DE GB**

(56) Documents cités:
**EP-A- 0 063 694**
**EP-A- 0 068 456**
**US-A- 3 633 031**
**US-A- 3 963 926**

**PATENTS ABSTRACTS OF JAPAN, vol. 6, no. 248 (P-160) [1126], 7 décembre 1982 & JP - A - 57 146 123**

(73) Titulaire: **COMMISSARIAT A L'ENERGIE ATOMIQUE, 31/33, rue de la Fédération, F-75015 Paris(FR)**

(72) Inventeur: **Amingual, Daniel, 2 rue Jean Mace, F-38000 Grenoble(FR)**
Inventeur: **Felix, Pierre, 8 boulevard Roger Salengro, F-38100 Grenoble(FR)**

(74) Mandataire: **Mongrédien, André et al, c/o BREVATOME 25, rue de Ponthieu, F-75008 Paris(FR)**

## Description

La présente invention concerne un dispositif matriciel de détection d'un rayonnement lumineux à écrans froids individuels intégrés dans un substrat et son procédé de fabrication.

L'invention s'applique notamment à un système d'imagerie infra-rouge tel qu'une caméra ou une lunette infra-rouge qui utilise une matrice de détecteurs infra-rouges comportant i détecteurs lignes et j détecteurs colonnes, i et j étant compris indépendamment entre 1 et 256 ; la matrice est éclairée par sa face arrière à travers un substrat transparent aux rayonnements.

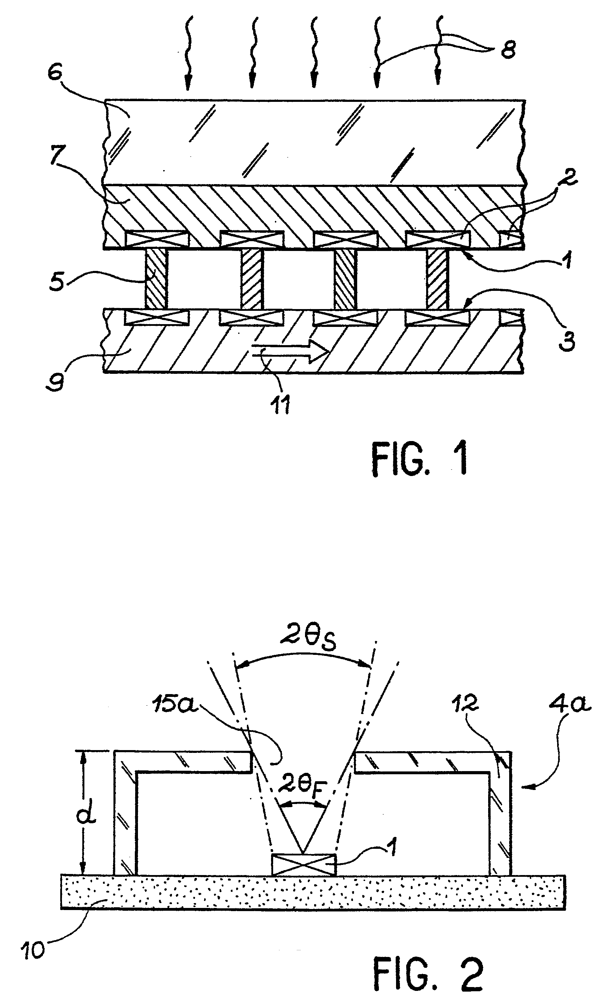

La figure 1 représente un système connu d'imagerie infra-rouge. Ce système est constitué de façon connue par deux matrices dont l'une, 1, assure la détection de rayonnements 8, et l'autre, 3, la lecture. Ces deux matrices 1, 3 sont reliées entre elles mécaniquement et électriquement par des plots métalliques 5. Les détecteurs 2 de la matrice de détection 1 sont par exemple des photodiodes réalisées dans un matériau semi-conducteur 7 par implantation ionique ou par diffusion d'atomes dans ledit matériau. Le matériau semi-conducteur 7 est un semi-conducteur de faible largeur de bande interdite comme le $Hg_{1-x}Cd_xTe$, x allant de 0 à 1. Il permet en ajustant la valeur de x, de couvrir un large domaine de longueur d'onde. Ce matériau semi-conducteur 7 est déposé en couches minces, d'épaisseur de l'ordre de 10 µm, par épitaxie sur un substrat transparent 6 aux rayonnements 8 à détecter. Pour un rayonnement 8 situé dans l'infra-rouge, on utilise un matériau tel que le tellurure de cadmium (CdTe), le saphir, l'arséniure de gallium (AsGa) ou l'antimoniure d'indium (InSb).

La matrice 3 de lecture est réalisée dans un matériau semi-conducteur 9 tel que du silicium monocristallin, en utilisant les techniques couramment employées dans la fabrication des circuits intégrés. Elle stocke les informations relatives à chaque détecteur 2, les lit séquentiellement et délivre des signaux électriques transmis par des conducteurs 11 à des moyens de traitement. Pour réduire le flux de photons incidents sur la matrice 1 de détecteurs, on associe généralement un écran unique à l'ensemble de la matrice 1 de détecteurs ou un écran à chaque détecteur 2 de cette matrice 1, ces écrans étant refroidis pour limiter le rayonnement thermique. Ces écrans permettent la réduction du flux incident, de telle sorte que chaque détecteur 2 constituant la matrice 1 ait un angle de vue aussi proche que possible de l'ouverture numérique de l'optique d'où proviennent les rayonnements 8. La réduction du flux de photons permet de réduire ainsi le bruit de fond des détecteurs et d'améliorer leur rendement. Elle permet également de réduire le courant continu délivré par chaque détecteur 2 et donc d'augmenter le temps d'intégration par la matrice 3 de lecture, pour une quantité de charge stockable donnée des éléments de ladite matrice 3 de lecture.

La figure 2 représente une matrice 1 de détecteurs associée de façon connue, à un écran froid unique. Celui-ci est généralement constitué par une céramique 10, refroidie par un gaz liquéfié ; au centre de cette céramique, est placée la matrice 1 de détecteurs et autour de ladite céramique sont disposées les parois 12 de l'écran refroidi 4a par contact thermique avec cette céramique 10.

L'écran froid 4a percé d'une ouverture 15a en regard de la matrice 1 de détecteurs est placé à une distance d au-dessus de celle-ci. L'ouverture numérique de l'optique d'où proviennent les rayonnements est représentée par l'angle $2\theta_S$, tandis que l'angle $2\theta_F$ représente l'angle sous lequel le centre de la matrice 1 de détecteurs voit le rayonnement incident.

Le rendement d'écran froid est défini comme étant le rapport entre les angles solides efficaces $\Omega_S = \pi\sin^2\theta_S$ correspondant à l'angle $\theta_S$ et $\Omega_F = \pi\sin^2\theta_F$ correspondant à l'angle $\theta_F$. Ainsi, le rendement d'écran froid $\eta$, est égal à :

$$\eta = \frac{\sin^2\theta_S}{\sin^2\theta_F}$$

$\eta$ représente donc le rapport entre le rayonnement lumineux incident arrivant sur l'ouverture de l'écran froid et le rayonnement lumineux détecté par la matrice de détection.

Avec un tel dispositif, il est d'autant plus difficile d'avoir un bon rendement $\eta$, que la dimension de la matrice 1 de détecteurs est grande et que l'ouverture 15a de l'écran froid 4a est petite. Par ailleurs, le rayonnement détecté n'est pas uniforme sur toute la matrice 1 de détecteurs ; il est plus faible sur les bords qu'au centre de la matrice 1.

Pour pallier ces inconvénients, on a envisagé d'associer à chacun des détecteurs d'une matrice 1 de détection un écran froid individuel. Ces écrans froids individuels apparaissent comme un réseau de trous réalisés dans un matériau et disposés au même pas que les détecteurs.

De tels écrans froids individuels sont notamment décrits dans le brevet américain n° 3 963 926 du 9 janvier 1975 et dans le brevet américain n° 4 446 372 du 1er juillet 1981. Par rapport à l'écran froid collectif, les écrans froids individuels présentent un certain nombre d'avantages tels que :

- la possibilité d'augmenter les dimensions de la matrice sans changer la géométrie des trous et donc de conserver le même rendement ;
- un éclairement homogène sur toute la matrice de détection ; il n'y a pas d'atténuation sur les bords de la matrice ;
- la consommation et la vitesse de mise à froid sont moins grandes.

Dans le brevet américain n° 3 963 926, il est décrit un procédé de fabrication d'écrans froids individuels associés à des détecteurs définis dans une tranche d'un matériau absorbant tel que du silicium dopé P+. Ce silicium est gravé sur toute son épaisseur par une solution d'attaque, suivant des lieux privilégiés définis par des masques. Le silicium ainsi percé de trous est fixé à un substrat par une résine époxyde. Ce substrat supporte sur sa face supérieure une matrice de détecteurs, chaque trou étant en face d'un détecteur de la matrice.

Ce procédé de fabrication présente certains inconvénients. En particulier, les écrans froids ainsi fabriqués constituent une pièce rapportée au système de détection. Par ailleurs, si le matériau constituant ces écrans est trop épais, les parois des ouvertures arrêtent une partie du rayonnement et le rendement de ces écrans froids est médiocre. De plus, les ouvertures créées dans le silicium de façon rapprochée fragilisent la structure de ces écrans froids.

Le brevet américain n° 4 446 372 correspondant à EP-A 0 068 456 décrit un procédé de fabrication d'écrans froids individuels, associés à des détecteurs définis dans un substrat transparent aux rayonnements lumineux à détecter. Les détecteurs sont formés par exemple par implantation ionique, dans un matériau de conduction épitaxié sur le substrat transparent. Sur la face supérieure du substrat est déposé un film mince opaque d'un matériau absorbant ou réfléchissant possédant des ouvertures. Ainsi, les détecteurs sont situés en regard de l'optique d'où proviennent les rayonnements lumineux à travers le substrat et les ouvertures du dépôt opaque. Ce film opaque protège les détecteurs des rayonnements électro-magnétiques et améliore la détection. Ce système de détection a une application très limitée à cause de la grande ouverture de l'angle de vue des détecteurs. En effet, un rayon extrême d'un faisceau arrivant sur une ouverture, peut atteindre un détecteur voisin de celui en regard de l'ouverture.

La présente invention a justement pour objet un dispositif matriciel de détection d'un rayonnement lumineux comportant une matrice de détecteurs associée à des écrans froids individuels et son procédé de fabrication, permettant de remédier aux inconvénients des différents dispositifs de détection décrits ci-dessus. Ce procédé permet en particulier d'obtenir, par un ensemble d'opérations simples, un dispositif de détection rigide, sans pièce rapportée, ayant un bon rendement d'écran froid.

De façon plus précise, l'invention a pour objet un dispositif matriciel de détection d'un rayonnement lumineux comprenant des détecteurs, répartis en matrice et définis dans un matériau de détection, et des écrans froids individuels, comprenant:

- un substrat transparent aux rayonnements, sur lequel est épitaxié le matériau de détection et comportant dans sa partie supérieure des trous borgnes répartis en matrice, chaque trou étant disposé en regard d'un détecteur,
- une couche de matériau transparent anti-réfléchissant recouvrant le fond des trous, permettant d'améliorer la photoréponse des détecteurs, et
- une couche d'un matériau absorbant les rayonnements recouvrant la face supérieure du substrat et les parois des trous, permettant d'améliorer le rendement d'écran froid.

De façon avantageuse, une couche d'un matériau opaque aux rayonnements recouvre au moins partiellement la périphérie du fond des trous permettant ainsi de délimiter avec précision la surface sensible de détection. Ce matériau opaque aux rayonnements est de préférence un matériau absorbant les rayonnements.

Le matériau transparent anti-réfléchissant permet de transmettre les rayonnements arrivant sur celui-ci. En revanche, le matériau absorbant absorbe les rayonnements qui tombent sur lui. Pour un détecteur donné, l'association de ces deux matériaux permet d'éliminer les rayonnements parasites issus par exemple de rayons réfléchis ou de rayons ne provenant pas du trou borgne correspondant.

L'invention a également pour objet un procédé de fabrication d'un dispositif matriciel de détection d'un rayonnement lumineux comportant des détecteurs et des écrans froids répartis en matrice, comprenant les étapes suivantes :

a) épitaxie d'un matériau de détection sur la face inférieure d'un substrat transparent aux rayonnements,
b) réalisation des détecteurs dans la couche du matériau de détection,
c) réalisation d'un masque sur la face supérieure du substrat, opposée à la face inférieure afin de masquer les parties du substrat non en regard desdits détecteurs,
d) gravure de la partie supérieure du substrat, à travers le masque, pour former des trous borgnes,
e) dépôt d'une couche d'un matériau transparent anti-réfléchissant sur la face supérieure gravée du substrat, les parois et le fond des trous,
f) dépôt d'une couche d'un matériau absorbant le rayonnement, sur la couche du matériau transparent anti-réfléchissant, au moins au-dessus de la face supérieure du substrat et des parois des trous.

Selon un mode préféré de mise en oeuvre du procédé de l'invention, le rayonnement étant un rayonnement infrarouge, le substrat est du tellurure de cadmium.

Selon un autre mode préféré de mise en oeuvre du procédé de l'invention, le matériau de détection d'un rayonnement infrarouge est du $Hg_{1-x}Cd_xTe$.

Selon un autre mode de mise en oeuvre du procédé de l'invention, l'étape c) consiste à :

- déposer sur la face supérieure du substrat une couche protectrice résistant à la gravure,
- réaliser sur la couche protectrice un masque en résine et
- graver la couche protectrice, à travers le masque de résine.

Selon un mode préféré de mise en oeuvre du procédé de l'invention, la couche protectrice est une couche d'alumine.

Selon un autre mode de mise en oeuvre du procédé de l'invention, la couche protectrice est une couche de métal.

Selon un mode de mise en oeuvre du procédé de l'invention, l'étape d) est effectuée par usinage ionique.

Selon un autre mode de mise en oeuvre du procédé de l'invention, le rayonnement étant un rayonnement infrarouge, le matériau transparent anti-réfléchissant est du sulfure de zinc.

De façon avantageuse, le matériau absorbant est un semi-conducteur absorbant ou un métal.

D'autres caractéristiques et avantages de l'invention ressortiront mieux de la description qui va suivre donnée à titre purement illustratif et non limitatif. L'ensemble des figures annexées suivantes représente :

- la figure 1 déjà décrite : un dispositif d'imagerie infra-rouge, d'un type connu ;
- la figure 2 déjà décrite : une matrice de détecteurs associée à un écran froid collectif, d'un type également connu ;
- la figure 3 : un dispositif de détection en perspective, formé d'une matrice de détecteurs associée à des écrans froids individuels conformément à l'invention.
- la figure 4 : une matrice de détecteurs aérée avec déplacement bi-directionnel de chaque détecteur selon neuf positions élémentaires,
- la figure 5 dans sa partie a : l'éclairement du dispositif de la figure 3 et dans sa partie b : le profil de l'éclairement obtenu avec un tel dispositif,
- les figures 6a à 6g : les différentes étapes du procédé de fabrication de la matrice de détecteurs avec écrans froids individuels intégrés dans un substrat transparent.

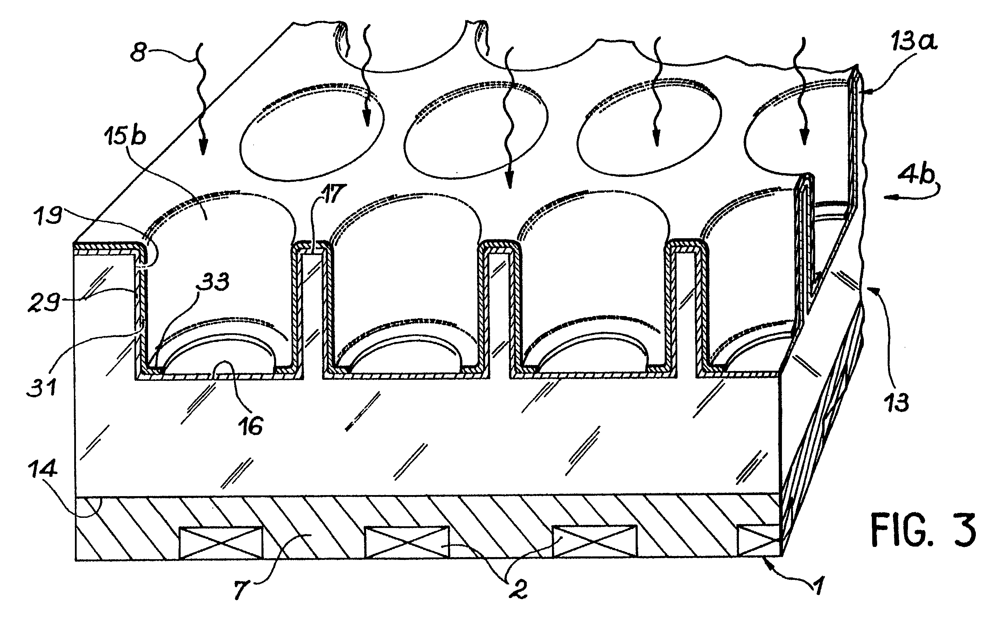

Sur la figure 3, on a représenté un dispositif conforme à l'invention comprenant une matrice 1 de détecteurs 2 associée à des écrans froids 4b individuels.

Sur cette figure, les détecteurs 2 notamment de forme parallélépipède rectangle, sont implantés dans un matériau semi-conducteur 7 tel que du $Hg_{1-x}Cd_xTe$, x allant de 0 à 1, d'une dizaine de $\mu m$ d'épaisseur. Ce matériau 7 est épitaxié sur la face inférieure 14 d'un substrat 13 transparent aux rayonnements lumineux 8 à détecter. Ce substrat 13 est constitué notamment par du CdTe d'une centaine de $\mu m$ d'épaisseur. Dans ce substrat 13, un réseau de trous borgnes 15b d'une cinquantaine de $\mu m$ de profondeur, sont répartis au même pas que les détecteurs 2 ; autrement dit, en regard de chaque détecteur 2, se trouve un unique trou 15b. Ces trous 15b constituent en partie les écrans froids individuels 4b. Ces trous 15b doivent avoir la plus grande surface possible compatible avec le pas des détecteurs 2 pour permettre une surface sensible élevée par détecteur 2.

La forme des trous 15b est fonction de celle des détecteurs 2. Dans le cas représenté, elle peut être circulaire, carrée ou intermédiaire. La forme circulaire favorise l'efficacité d'écran froid, tandis qu'elle diminue la surface sensible de détection. La face supérieure 17 du substrat transparent 13, les parois 19 et le fond 16 des trous 15b, sont recouverts d'une couche 29 d'un matériau transparent anti-reflet pour améliorer la photo-réponse des détecteurs 2. Ceci n'est qu'un exemple de réalisation, on peut envisager de ne recouvrir que le fond des trous par le matériau transparent anti-reflet. Pour améliorer le rendement de ces écrans froids, les parois verticales 19 des trous 15b ainsi que la face supérieure 17 du substrat transparent 13, sont recouverts d'une deuxième couche 31 d'une substance absorbant le rayonnement lumineux 8.

De plus, pour délimiter avec précision la surface sensible de chaque détecteur qui peut fluctuer d'un détecteur à l'autre, une couche 33 d'un matériau opaque aux rayonnements lumineux peut être prévue à la périphérie du fond 16 de chaque trou 15b. Cette couche 33 peut être réalisée en un matériau absorbant ou réfléchissant.

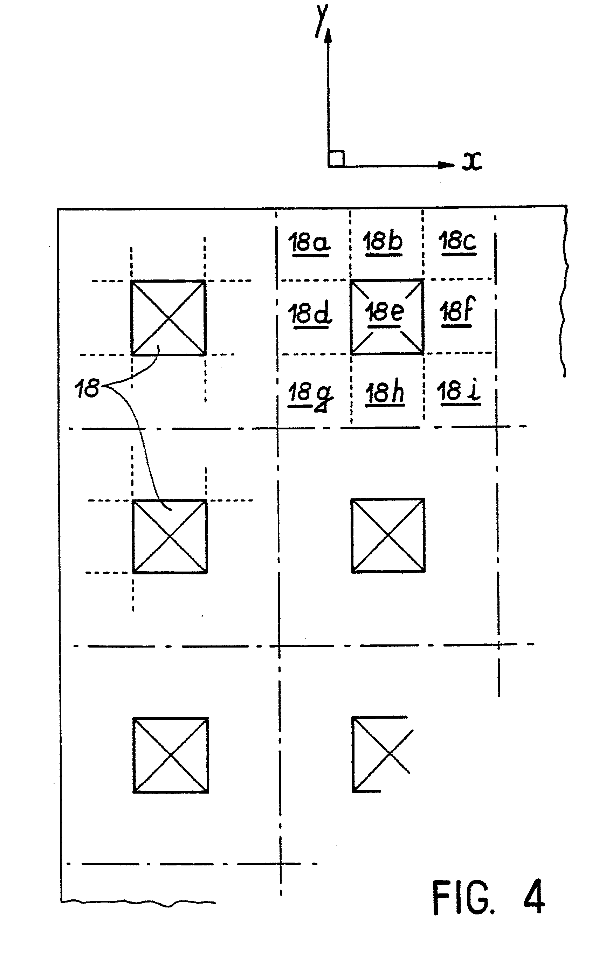

Sur la figure 3 décrite ci-dessus, les écrans froids sont associés à des détecteurs 2 fixes, mais ils peuvent également être appliqués à une matrice de détecteurs beaucoup plus espacés que précédemment, utilisée dans des systèmes à balayage optomécanique unidirectionnel ou bidirectionnel connus. Une matrice de détecteurs avec balayage bidirectionnel est représentée sur la figure 4. Dans de telles matrices, chaque détecteur 18 est déplacé dans une ou deux directions x ou y contenues dans le plan de la matrice par action mécanique selon n ou $n \times n$ positions élémentaires, respectivement pour un balayage unidirectionnel ou bidirectionnel. Il reçoit successivement pendant un temps d'image, les informations relatives aux n ou $n^2$ points d'images élémentaires, respectivement pour un balayage unidirectionnel ou bidirectionnel.

Sur la figure 4, représentant une matrice de détecteur avec balayage bidirectionnel, n est égal à 3. Chaque détecteur 18 a donc de ce fait neuf positions élémentaires de 18a à 18i. Par suite de l'espacement plus important entre détecteurs, les trous effectués dans un substrat transparent aux rayonnements lumineux à détecter, peuvent être plus profonds, de l'ordre d'une centaine de $\mu m$, afin que l'angle de vue de chaque détecteur soit beaucoup plus fermé.

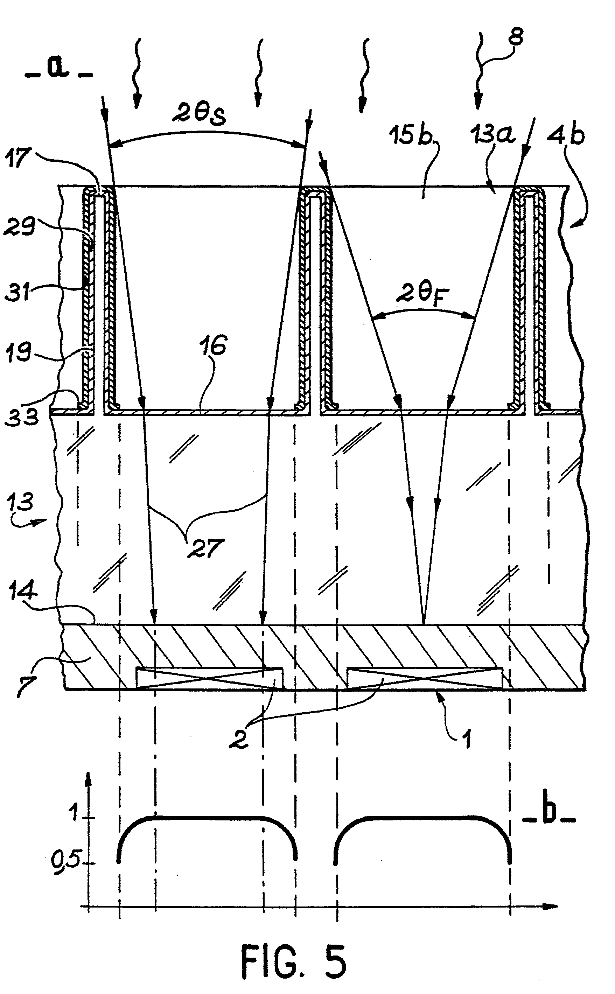

La figure 5 représente schématiquement, dans sa partie a : une coupe longitudinale d'un dispositif selon la figure 3 d'une matrice 1 de détecteurs 2 associée à des écrans froids 4b individuels, et dans sa partie b : le profil de l'éclairement obtenu avec une telle structure.

On retrouve dans la partie a, les détecteurs 2 implantés dans un matériau conducteur 7, celui-ci étant épitaxié sur la face inférieure 14 d'un substrat 13 transparent aux rayonnements lumineux 8 à détecter. La face supérieure 17 du substrat 13, les parois 19 et le fond 16 des trous 15b sont recouverts d'une couche 29 d'un matériau transparent anti-réfléchissant. Cette couche 29 est recouverte, sauf au fond 16 des trous 15b, d'une couche 31 d'un matériau absorbant le rayonnement 8 à détecter. Sur la périphérie des trous 15b est déposée une couche 33 d'un matériau opaque aux rayonnements. L'ouverture de l'optique d'où proviennent les rayonnements est représentée par l'angle $2\theta_S$, tandis que l'angle $2\theta_F$ représente l'angle sous lequel le centre d'un détecteur voit le rayonnement lumineux 8. Les rayons lumineux extrêmes 27, transmis par le substrat 13, délimitent la zone de sensibilité maximale d'un détecteur 2. Avec cette structure, on voit dans la partie b de la figure 5 que l'éclairement issu de l'optique d'où proviennent ces rayonnements 8, normalisé à l'unité, est maximal sur la surface centrale de chaque détecteur, représentant environ la moitié de sa surface. l'éclairement décroît ensuite sur les bords des détecteurs 2 jusqu'à 50% de sa valeur maximale.

Le rendement η des écrans froids individuels 4b est calculé à partir de la formule :

$$\eta = \frac{\sin^2 \theta_S}{\sin^2 \theta_F}$$

Ainsi, avec un substrat en CdTe de 100 µm d'épaisseur, des trous de 50 µm de profondeur et une ouverture de l'optique d'où proviennent les rayonnements correspondant à une angle $\theta_S = 10°$, on a un rendement d'écrans froids de l'ordre de 26% pour une épaisseur entre parois 19 inférieure à 3 µm et de 23% pour une épaisseur entre parois 19 de 3 µm.

Pour une matrice de détecteurs espacés, comme représentée sur la figure 4, associés à des écrans froids individuels, la profondeur des trous étant plus importante et l'angle $\theta_F$ étant de ce fait plus fermé, le rendement η des écrans froids est plus important.

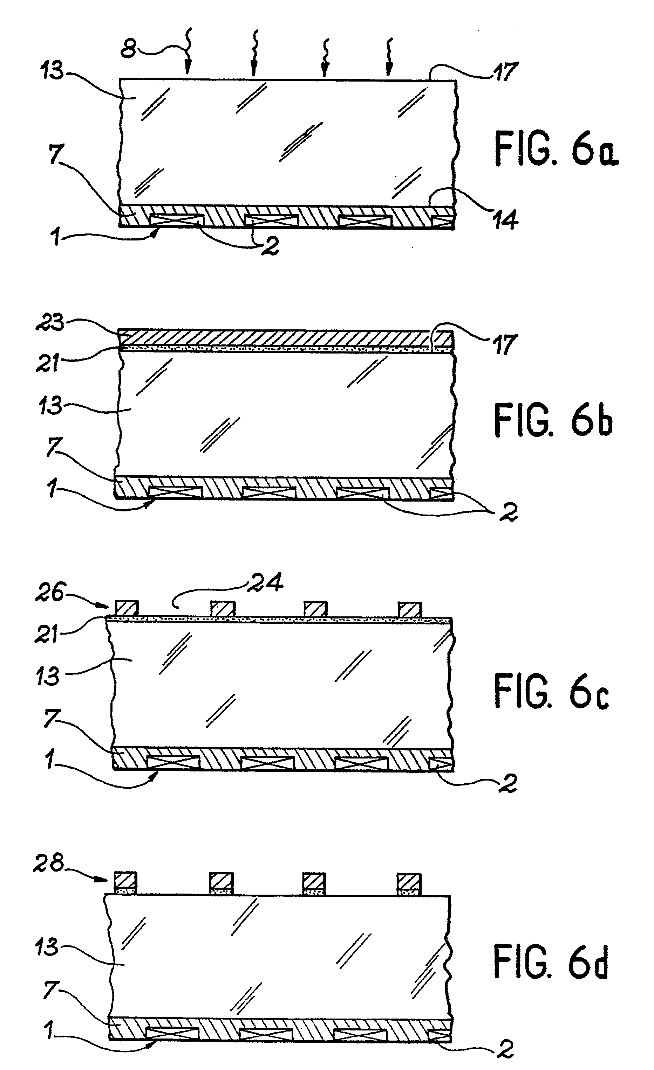

Les figures 6a à 6g représentent les différentes étapes du procédé de fabrication d'un dispositif matriciel de détection d'un rayonnement lumineux comprenant des détecteurs en matrice associés à des écrans froids individuels.

La première étape du procédé, comme représenté sur la figure 6a, consiste à définir une matrice 1 de détecteurs 2 par implantation d'ions ou diffusion d'atomes dans un matériau semi-conducteur 7 épitaxié sur la face inférieure 14 d'un substrat 13 transparent aux rayonnements lumineux 8 à détecter et d'épaisseur désirée. Cette matrice de détecteurs peut se faire, soit avant la réalisation des écrans froids individuels, comme décrit ici, soit à la fin de la réalisation de ces écrans froids. Dans le cas d'un dispositif de détection infra-rouge, la matériau semi-conducteur 7, peut être du $Hg_{1-x}Cd_xTe$, x allant de 0 à 1, d'une épaisseur de 10 µm, épitaxié sur un substrat 13 de CdTe transparent aux rayonnements infra-rouges. Le substrat d'origine, en CdTe, a une épaisseur moyenne de 500 µm ; il est donc préalablement aminci par des moyens mécaniques et chimiques classiques jusqu'à une centaine de µm.

L'étape suivante, comme illustré sur la figure 6b, consiste à déposer sur la face supérieure 17 de ce substrat 13 une première couche protectrice 21 d'un matériau résistant à la gravure ionique ou ionique réactif suivant le type d'usinage utilisé pour la gravure du substrat 13. La couche protectrice 21 peut être une couche d'alumine d'une épaisseur de 2 µm ou une couche d'un métal tel que le platine, le nickel, le chrome, d'une épaisseur d'un µm par exemple. Cette couche protectrice 21 peut être déposée par pulvérisation cathodique.

On dépose ensuite sur la couche protectrice 21 une deuxième couche 23 d'une résine photosensible positive ou négative, par exemple une résine positive telle que la résine AZ 1350, de 4 µm d'épaisseur.

L'étape suivante, comme illustrée sur la figure 6c consiste à réaliser un masque 26 en résine comportant des ouvertures 24 situées en face de chaque détecteur 2, par insolation locale de la couche de résine photosensible 23 puis développement de celle-ci. Les ouvertures 24 à réaliser, sont alignées en face de chaque détecteur 2, par exemple par positionnement des détecteurs 2 par rapport à un réticule, l'ensemble détecteur 2 plus substrat 13 étant fixé, puis retourné pour aligner les ouvertures 24 à réaliser dans la résine 23 sur des repères placés à l'extérieur du réticule. On peut également aligner les détecteurs 2 et les ouvertures 24 à créer en une seule opération, au moyen de deux microscopes face à face, comportant le même axe optique : l'alignement se fait alors au moyen de moniteurs vidéo.

L'étape suivante, comme illustrée sur la figure 6d, consiste à graver, à travers le masque 26, la couche protectrice 21 sur toute son épaisseur, par une attaque chimique ou un usinage ionique. Pour une couche protectrice en alumine, la gravure peut être effectuée par attaque chimique avec une solution de $H_3PO_4$ et d'alcool isopropylique à une température de 80°C ou bien avec une solution de $H_2SO_4$ à 10% à une température de 40 ou 60°C. Pour une couche protectrice 21 métallique, cette gravure peut être faite par usinage ionique.

La couche 21 ainsi gravée et la masque de résine 26 constituent un masque bicouche 28 pour la gravure du substrat 13.

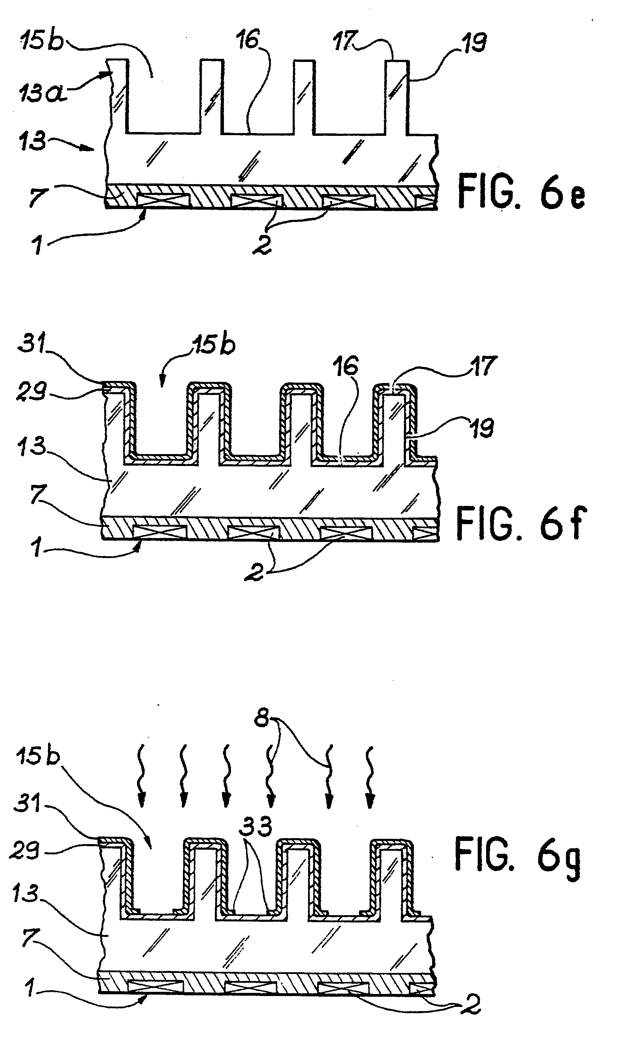

L'étape suivante, illustrée par la figure 6e, consiste alors à graver des trous borgnes 15b dans la partie supérieure 13a du substrat transparent 13, par un usinage ionique ou ionique réactif, aux endroits non masqués par la couche de résine 23 et la couche protectrice 21 gravées, celles-ci disparaissant lors de la gravure des trous 15b. Avec les vitesses de gravure suivantes : alumine : 100 AÅ/mn, résine AZ 1350 : 300 AÅ/mn et CdTe : 1500 AÅ/mn, la couche 21 de résine de 4 µm d'épaisseur ajoutée à la couche 23 d'alumine de 2 µm d'épaisseur mettront le même temps à se graver que 50 µm de substrat 13 en CdTe. Dans le cas où la couche protectrice 21 est une couche métallique, on grave le substrat 13 sous pression partielle d'oxygène pour ralentir la vitesse de gravure du métal qui passe de 500 AÅ/mn à moins de 50 AÅ/mn.

L'étape suivante, illustrée par la figure 6f consiste à déposer sur toute la surface crénelée par les trous 15b du substrat 13, c'est-à-dire sur la face supérieure 17 du substrat 13, sur les parois 19 et le fond 16 des trous 15b, une première couche 29 d'un matériau transparent anti-réfléchissant, puis une deuxième couche mince 31 d'un matériau absorbant le rayonnement lumineux 8 à détecter. Le matériau transparent anti-réfléchissant est constitué par exemple par du sulfure de zinc, de 1 µm d'épaisseur environ pour des rayonnements infra-rouges dont la longueur d'onde est comprise entre 8 et 12 µm et de 0,5 µm d'épaisseur pour des rayonnements infra-rouges dont la longueur d'onde est comprise entre 3 et 5 µm. La couche 31 d'un matériau absorbant les rayonnements infra-rouges est déposée en couche mince, inférieure à 1 µm, sur la couche 29 du matériau transparent anti-réfléchissant par évaporation d'un semi-conducteur absorbant ou d'un métal tel que l'or, sous pression résiduelle d'oxygène ou par voie chimique.

La dernière étape du procédé de fabrication représentée sur la figure 6g, consiste à graver la couche absorbante 31 de façon à éliminer le matériau absorbant de toute la surface ou de la surface centrale du fond des trous 15b pour obtenir la surface sensible détectrice désirée. Les gravures dans le fond des trous 15b de la couche absorbante 31 sont réalisées par exemple par des techniques de gravure ionique réalisée à travers un masque de résine. Celui-ci peut être obtenu par dépôt d'une résine, insolation puis développement de cette résine. Le dépôt de la résine est effectué par exemple à l'aide d'une machine de dépôt par brouillard de particules chargées de façon électrostatique. L'insolation de la résine au fond des trous 15b peut être effectuée avec une machine par projection qui donne une précision bien supérieure à l'utilisation d'un positionneur classique par contact.

La couche absorbante 31 peut être déposée directement sur la face supérieure du substrat 17 et les parois 19 des trous 15b par évaporation du matériau absorbant sur le substrat 13. Celui-ci est alors disposé sur un support rotatif, incliné de telle manière que les particules du matériau absorbant se déposent jusqu'au bas des parois 19 des trous 15b.

Lorsqu'il n'y a pas de matériau absorbant au fond des trous 15b, on peut déposer une couche 33 d'un matériau opaque aux rayonnements tel qu'un matériau réfléchissant ou absorbant, à la périphérie du fond des trous 15b pour délimiter la surface sensible de détection.

Dans le dispositif de détection de l'invention, les écrans froids individuels sont notamment intégrés dans le substrat, ils ne sont donc pas constitués par une pièce rapportée contrairement à l'art antérieur. De plus, les différentes étapes de mise en oeuvre de ces écrans utilisent des techniques de gravure et de dépôt bien connues faciles à mettre en oeuvre.

## Revendications

1. Dispositif matriciel de détection d'un rayonnement lumineux comprenant des détecteurs (2) répartis en matrice (1) et définis dans un matériau de détection (7), des écrans froids individuels, et un substrat (13) transparent aux rayonnements (8), sur lequel est épitaxié la matériau de détection (7) caractérisé en ce qu'il comprend:
   - dans sa partie supérieure du substrat (13a) des trous borgnes (15b) répartis en matrice, chaque trou (15b) étant disposé en regard d'un détecteur (2),
   - une couche de matériau transparent anti-réfléchissant (29) recouvrant le fond (16) des trous (15b), et
   - une couche d'un matériau (31) absorbant les rayonnements recouvrant la face supérieure (17) du substrat (13) et les parois (19) des trous (15b).

2. Dispositif selon la revendication 1, caractérisé en ce qu'il comprend une couche d'un matériau opaque (33) recouvrant au moins partiellement la périphérie du fond (16) des trous (15b).

3. Procédé de fabrication d'un dispositif matriciel de détection d'un rayonnement lumineux comportant des détecteurs et des écrans froids répartis en matrice, comprenant les étapes suivantes :
   a) épitaxie d'un matériau de détection (7) sur la face inférieure (14) d'un substrat (13) transparent aux rayonnements (8),
   b) réalisation des détecteurs (2) dans la couche du matériau de détection (7),
   c) réalisation d'un masque (28) sur la face supérieure (17) du substrat (13), opposée à la face inférieure (14) afin de masquer les parties du substrat (13) non en regard desdits détecteurs (2),
   d) gravure de la partie supérieure (13a) du substrat (13), à travers le masque (28), pour former des trous borgnes (15b),
   e) dépôt d'une couche d'un matériau transparent anti-réfléchissant (29) sur la face supérieure (17) gravée du substrat (13), les parois (19) et le fond (16) des trous (15b),
   f) dépôt d'une couche d'un matériau (31) absorbant le rayonnement, sur la couche du matériau transparent anti-réfléchissant (29), au moins au-dessus de la face supérieure (17) du substrat (13) et des parois (19) des trous (15b).

4. Procédé selon la revendication 3, caractérisé en ce que, le rayonnement (8) étant un rayonnement infra-rouge, le substrat (13) est du tellurure de cadmium.

5. Procédé selon l'une quelconque des revendications 3 et 4, caractérisé en ce que le matériau de détection (7) d'un rayonnement infra-rouge est du $Hg_{1-x}Cd_xTe$.

6. Procédé selon l'une quelconque des revendications 3 à 5, caractérisé en ce que l'étape (c) consiste à :
   - déposer sur la face supérieure (17) une couche protectrice (21) résistant à la gravure,
   - réaliser sur la couche protectrice (21), un masque (26) en résine, et
   - graver la couche protectrice (21), à travers le masque (26).

7. Procédé selon la revendication 6, caractérisé en ce que la couche protectrice (21) est une couche d'alumine.

8. Procédé selon la revendication 7, caractérisé en ce que la gravure de la couche d'alumine (21) est effectuée avec une solution d'attaque comprenant de l'acide orthophosphorique et de l'alcool isopropylique à 80°C.

9. Procédé selon la revendication 7, caractérisé en ce que la gravure de la couche d'alumine (21) est effectuée avec une solution d'acide sulfurique 0,1 molaire à une température comprise entre 40 et 60°C.

10. Procédé selon la revendication 6, caractérisé en ce que la couche protectrice (21) est une couche de métal.

11. Procédé selon la revendication 10, caractérisé en ce que la gravure de la couche métallique (21) est effectuée par un usinage ionique.

12. Procédé selon l'une quelconque des revendications 3 à 11, caractérisé en ce que l'étape d) est effectuée par usinage ionique.

13. Procédé selon l'une quelconque des revendications 3 à 12, caractérisé en ce que le rayonnement étant un rayonnement infrarouge, le matériau transparent anti-réfléchissant (29) est du sulfure de zinc.

14. Procédé selon l'une quelconque des revendications 3 à 13, caractérisé en ce que le matériau absorbant (31) est un semi-conducteur absorbant.

15. Procédé selon l'une quelconque des revendications 3 à 13, caractérisé en ce que le matériau absorbant (31) est un métal.

## Claims

1. Matrix device for the detection of light radiation comprising detectors (2) distributed in matrix-like manner and defined in a detection material (7), individual cold screens and a radiation (8)-transparent substrate (13), on which is epitaxied the detection material (7), characterized in that it comprises in the upper part of substrate (13a) with blind holes (15b) distributed in matrix-like manner, each hole (15b) facing a detector (2), a layer of transparent anti-reflecting material (29) covering the bottom (16) of the holes (15b) and a layer of a radiation-absorbing material (31) covering the upper face (17) of the substrate (13) and the walls (19) of the holes (15b).

2. Device according to claim 1, characterized in that it comprises a layer of an opaque material (33) at least partly covering the periphery of the bottom (16) of the holes (15b).

3. Process for the production of a matrix device for the detection of light radiation having detectors and cold screens distributed in matrix-like manner comprising the following stages:

a) epitaxy of a detection material (7) on the lower face (14) of a radiation (8)-transparent substrate (13),

b) formation of detectors (2) in the detection material layer (7),

c) formation of a mask (28) on the upper face (17) of the substrate (13) opposite to the lower face (14), so as to mask those parts of the substrate (13) not facing said detectors (2),

d) etching the upper part (13a) of the substrate (13) through the mask to form blind holes (15b),

e) deposition of a layer of an anti-reflecting transparent material (29) on the upper etched face (17) of the substrate (13), the walls (19) and the bottom (16) of the holes (15b),

f) deposition of a layer of a radiation-absorbing material (31) on the anti-reflecting transparent material (29) layer, at least above the upper face (17) of the substrate (13) and the walls (19) of the holes (15b).

4. Process according to claim 3, characterized in that as the radiation (8) is infrared radiation, the substrate (13) is of cadmium telluride.

5. Process according to either of the claims 3 and 4, characterized in that the infrared radiation detection material (7) is of $Hg_{1-x}Cd_xTe$.

6. Process according to any one of the claims 3 to 5, characterized in that stage (c) consists of depositing on the upper face (17) an etching-resistant protective layer (21), forming a resin mask (26) on the protective layer (21) and etching said layer (21) through the mask (26).

7. Process according to claim 6, characterized in that the protective layer (21) is an alumina layer.

8. Process according to claim 7, characterized in that the etching of the alumina layer (21) takes place with an etching solution containing orthophosphoric acid and isopropyl alcohol at 80°C.

9. Process according to claim 7, characterized in that the etching of the alumina layer (21) takes place with a 0.1 m sulphuric acid solution at a temperature between 40 and 60°C.

10. Process according to claim 6, characterized in that the protective layer (21) is a metal layer.

11. Process according to claim 10, characterized in that the etching of the metal layer (21) takes place by ionic machining.

12. Process according to any one of the claims 3 to 11, characterized in that stage d) is performed by ionic machining.

13. Process according to any one of the claims 3 to 12, characterized in that as the radiation is infrared radiation, the transparent anti-reflecting material (29) is zinc sulphide.

14. Process according to any one of the claims 3 to 13, characterized in that the absorbent material (31) is an absorbent semiconductor.

15. Process according to any one of the claims 3 to 13, characterized in that the absorbent material (31) is a metal.

## Patentansprüche

1. Matrixartige Detektoranordnung für Lichtstrahlung mit nach einer Matrix (1) verteilten und in einem Detektormaterial (7) festgelegten Detektoren (2), einzelnen kalten Schirmen und einem für die Strahlung (8) transparenten Substrat, auf welchem das Detektormaterial (7) (durch Epitaxie) aufgewachsen ist, dadurch gekennzeichnet, daß sie aufweist:

– in dem oberen Teil des Substrats (13a) nach einer Matrix verteilte Blindlöcher (15b), wobei jedes Loch (15b) gegenüber einem Detektor (2) angeordnet ist,

– eine Schicht aus transparentem, nicht reflektierenden Material (29), welche den Boden (16) der Löcher (15b) bedeckt, und

– eine Schicht aus einem die Strahlung absorbierenden Material (31), welche die Oberseite (17) des Substrats und die Wände (19) der Löcher (15b) bedeckt.

2. Anordnung nach Anspruch 1, dadurch gekennzeichnet, daß sie eine Schicht eines lichtundurchlässigen Materials (33) enthält, welche mindestens teilweise den bodenseitigen Rand (16) der Löcher (15b) bedeckt.

3. Verfahren zur Herstellung einer matrixartigen Detektoranordnung für Lichtstrahlung, welche Detektoren und kalte Schirme, die nach einer Matrix verteilt sind, aufweist, mit folgenden Schritten:

a) Aufwachsen eines Detektormaterials (7) auf der Unterseite (14) eines für die Strahlung (8) transparenten Substrats (13),

b) Ausbildung der Detektoren (2) in der Schicht des Detektormaterials (7),

c) Ausbildung einer Maske (28) auf der Oberseite (17) des Substrats (13), der Unterseite (14) gegenüberliegend, um diejenigen Teile des Substrats (13) abzudecken, welche nicht den genannten Detektoren (2) gegenüberliegen,

d) Ätzung der Oberseite (13a) des Substrats (13) durch die Maske (28) hindurch, um Blindlöcher (15b) auszubilden,

e) Aufbringen einer Schicht aus transparentem, nicht reflektierendem Material (29) auf die geätzte Oberseite (17) des Substrats (13), die Wände (19) und den Boden (16) der Löcher (15b),

f) Aufbringen einer Schicht eines die Strahlung absorbierenden Materials (31) auf die Schicht des transparenten nicht reflektierenden Materials (29), zumindest auf den Oberseite (17) des Subtrats (13) und die Wände (19) der Löcher (15b).

4. Verfahren nach Anspruch 3, dadurch gekennzeichnet, daß, wenn die Strahlung (8) eine Infrarotstrahlung ist, das Substrat (13) aus Kadmiumtellurit besteht.

5. Verfahren nach einem der Ansprüche 3 und 4, dadurch gekennzeichnet, daß das Detektormaterial (7) für Infrarotstrahlung aus $Hg_{1-x}Cd_xTe$ besteht.

6. Verfahren nach einem der Ansprüche 3 bis 5, dadurch gekennzeichnet, daß der Schritt c) besteht aus:

— Ablagerung einer der Ätzung widerstehenden Schutzschicht (21) auf der Oberseite (17),

— Herstellung einer Maske (26) aus Harz auf der Schutzschicht (21) und

— Ätzung der Schutzschicht (21) durch die Maske (26) hindurch.

7. Verfahren nach Anspruch 6, dadurch gekennzeichnet, daß die Schutzschicht (21) eine Aluminiumschicht ist.

8. Verfahren nach Anspruch 7, dadurch gekennzeichnet, daß die Ätzung der Aluminiumschicht (21) mit einer Ätzlösung ausgeführt wird, welche Orthophosphorsäure und Isopropylalkohol mit einer Temperatur von 80°C enthält.

9. Verfahren nach Anspruch 7, dadurch gekennzeichnet, daß die Ätzung der Aluminiumschicht (21) mit einer 0,1-molaren Schwefelsäurelösung bei einer zwischen 40 und 60°C gehaltenen Temperatur durchgeführt wird.

10. Verfahren nach Anspruch 6, dadurch gekennzeichnet, daß die Schutzschicht (21) eine Metallschicht ist.

11. Verfahren nach Anspruch 10, dadurch gekennzeichnet, daß die Ätzung der metallischen Schicht (21) durch Ionenerosion erfolgt.

12. Verfahren nach einem der Ansprüche 3 bis 11, dadurch gekennzeichnet, daß der Schritt d) durch Ionenerosion erfolgt.

13. Verfahren nach einem der Ansprüche 3 bis 12, dadurch gekennzeichnet, daß, wenn die Strahlung eine Infrarotstrahlung ist, das transparente, nicht reflektierende Material (29) aus Zinksulfid besteht.

14. Verfahren nach einem der Ansprüche 3 bis 13, dadurch gekennzeichnet, daß das absorbierende Material (31) ein halbleitendes absorbierendes Material ist.

15. Verfahren nach einem der Ansprüche 3 bis 13, dadurch gekennzeichnet, daß das absorbierende Material (31) ein Metall ist.

FIG. 1

FIG. 2

FIG. 3

FIG. 4

FIG. 5

FIG. 6a

FIG. 6b

FIG. 6c

FIG. 6d

FIG. 6e

FIG. 6f

FIG. 6g